Europäisches Patentamt

European Patent Office

Office européen des brevets

(19)

(11) Numéro de publication: **0 244 479
B1**

## (12) FASCICULE DE BREVET EUROPEEN

(45) Date de publication du fascicule du brevet: **04.04.90**

(51) Int. Cl.⁵: **C 30 B 15/00**

(21) Numéro de dépôt: **86907238.9**

(22) Date de dépôt: **15.09.86**

(86) Numéro de dépót international:
**PCT/FR86/00308**

(87) Numéro de publication internationale:
**WO 87/01741 26.03.87 Gazette 87/07**

(54) **PROCEDE DE FABRICATION D'UN SUBSTRAT SEMI-ISOLANT EN MATERIAU III-V NON DISLOQUE ET STABILE THERMIQUEMENT.**

(30) Priorité: **20.09.85 FR 8513982**

(43) Date de publication de la demande:
**11.11.87 Bulletin 87/46**

(45) Mention de la délivrance du brevet:
**04.04.90 Bulletin 90/14**

(84) Etats contractants désignés:
**DE GB IT NL SE**

(56) Documents cités:
**EP-A-0 160 373
FR-A-1 409 116
US-A-3 496 118**

(73) Titulaire: **ETAT FRANCAIS représenté par le Ministre des PTT (Centre National d'Etudes des Télécommunications)
38-40 rue du Général Leclerc
F-92131 Issy-les-Moulineaux (FR)**

(73) Titulaire: **CENTRE NATIONAL DE LA RECHERCHE SCIENTIFIQUE (CNRS)
15, Quai Anatole France
F-75700 Paris Cedex 07 (FR)**

(72) Inventeur: **CLERJAUD, Bernard
18, rue des Chantereines
F-93100 Montreuil (FR)**
Inventeur: **DEVEAUD, Benoît
44, résidence Duroux
F-22300 Lannion (FR)**
Inventeur: **FAVENNEC, Pierre Noel
Crec'h Lia Begleguer
F-22300 Lannion (FR)**

(74) Mandataire: **Mongrédien, André et al
c/o BREVATOME 25, rue de Ponthieu
F-75008 Paris (FR)**

Courier Press, Leamington Spa, England.

## Description

La présente invention a pour objet un procédé de fabrication d'un substrat monocristallin semi-isolant en matériau III—V, ce substrat étant non disloqué et stable thermiquement à la température de recuit dudit substrat.

Les matériaux à base d'éléments III et V de la classification périodique des éléments sont de plus en plus promus à un bel avenir pour la réalisation de circuits intégrés logiques et de transistors à effet de champ de fonctionnement rapide. Malheureusement, l'utilisation de ces matériaux III—V est actuellement limitée par les difficultés à obtenir de grands monocristaux, semi-isolants, stables thermiquement et peu disloqués.

On rappelle que les matériaux semi-isolants sont des matériaux dont le niveau de Fermi se situe au milieu de la bande interdite de ces matériaux.

Les substrats en matériau III—V et en particulier en GaAs ou InP furent, dans un premier temps, réalisés en utilisant les centres electro-accepteurs profonds créés par un métal de transition dans le matériau III—V. Pour les substrats en GaAs, on utilise le chrome et pour les substrats en InP, le fer.

Le chrome et le fer jouent le même rôle. Ils servent à compenser les impuretés électrodonneuses des substrats inhérentes à la fabrication de ces substrats. Ces impuretés sont liées certes à la difficulté qu'il y a d'obtenir des produits de départ, gallium et arsenic d'une part et indium et phosphore d'autre part, 100% purs, mais plus spécialement aux conditions opératoires relatives à la fabrication de monocristaux.

Les impuretés les plus remarquables aussi bien pour GaAs que InP sont des impuretés de silicium provenant des creusets réfractaires en oxyde de silicium généralement utilisés pour contenir le bain fondu à partir duquel on forme les monocristaux.

L'effet compensatoire du chrome ou du fer dans les substrats en GaAs ou Inp permettait certes l'obtention de substrats bien semi-isolants, mais certaines difficultés sont très vite apparues, lors de la réalisation d'épitaxie sur de tels substrats ou d'implantations d'ions dans ces substrats en vue de la fabrication de transistors à effet de champ ou de circuits logiques.

En effet, lors de la croissance épitaxiale d'une couche semiconductrice sur un substrat en GaAs dopé au chrome, le chrome exodiffuse du substrat vers la couche épitaxiée modifiant les propriétés électriques de cette couche. Pour pallier à cet inconvénient, on est donc amené à faire croître une couche tampon de GaAs dans laquelle diffuse le chrome, avant de faire croître le couche semiconductrice ayant les propriétés électriques désirées. Mais cette solution n'est pas satisfaisante. En effet, la couche tampon n'est pas reproductible du point de vue propriétés électriques. Par ailleurs, ses qualités électriques et en particulier sa résistivité ne sont pas aussi bonnes que celles du substrat dopé au chrome.

De même, dans le cas d'un recuit thermique d'un substrat en GaAs dopé au chrome ou d'un substrat en InP dopé au fer, consécutif à une implantation ionique servant à guérir les défauts dans ces substrats, le chrome ou le fer exodiffusent et se redistribuent à la surface du substrat correspondant. Il en résulte des pics de concentration en chrome ou en fer très près de la surface du substrat correspondant suivie d'une déplétion ou d'un appauvrissement en métal de transition, sur environ 1 µm d'épaisseur, du substrat. La zone appauvrie en métal de transition a alors perdu son caractére semi-isolant. Bien entendu, un tel comportement rend très difficile la réalisation d'implantations ioniques reproductibles et donc la fabrication, de façon reproductive, de circuits ou de transistors intégrés.

Dans un second temps, on a essayé de réaliser des substrats semi-isolants en GaAs monocristallin selon un autre principe. Cette méthode consiste à faire croître le substrat en GaAs par la méthode de Czochralski dans un creuset en nitrure de bore (NB), le bain fondu à partir duquel sera formé le monocristal étant recouvert ou encapsulé par un matériau tel que l'oxyde de bore ($B_2O_3$) ayant un point de fusion inférieur à celui de GaAs. Cette méthode bien connue de l'homme de l'art est décrite en particulier dans un article de Semi-Insulating III—V Materials de 1984 intitulé "Crystal Growth of Semi-Insuating Gallium Arsenide" de R. K. Willardson pages 96—109. Elle permet d'obtenir des substrats en GaAs dont les impuretés résiduelles sont compensées par des défauts de stoechiométrie des substrats, appelés EL2, électro-donneurs profonds. Ces défauts sont liés à un anti-site, c'est-à-dire à la présence d'un atome d'arsenic en site gallium.

La compensation des impuretés résiduelles de type p des substrats en GaAs, principalement du carbone à une concentration de $1—3\ 10^{15}$ atomes/ $cm^3$ dans le cas présent, est obtenue en utilisant une surstoechiométrie d'arsenic (+ 2% en poids) dans le bain de croissance, créant typiquement $10^{16}$ anti-sites.

Bien que ces anti-sites diffusent moins que le chrome, ils sont instables thermiquement. En effet, un recuit du substrat en GaAs à une température de l'ordre de 950°C conduit à une guérison de ces anti-sites et donc à la disparition du caractére semi-isolant du substrat. Cette température de 950°C est celle généralement utilisée pour guérir les défauts du substrat engendrés lors d'une implantation ionique dudit substrat.

En plus des problèmes liés à la compensation des impuretés des substrats en matériau III—V pour avoir des substrats semi-isolants, que ce soit par le chrome ou les anti-sites pour GaAs ou le fer pour InP, il faut adjouter les problèmes liés au nombre de dislocations de ces substrats. La concentration des dislocations varie de $10^4$ à $10^5$ par $cm^2$; elle présente des maximums au centre du substrat ainsi qu'aux bords. Or la présence de ces dislocations affecte considérablement les performances des dispositifs réalisés sur ces substrats. On observe en particulier une inhomogénéité importante des tensions de seuil des transistors à effet de champ réalisés sur des substrats disloqués.

Des études récentes sur la cristallogénése du GaAs, publiées dans un article de Semi-Insulating III—V Materials de 1985 intitulé "Growth and characterization of Large Dislocation-Free GaAs Crystals for Integrated Circuits Applications" pages 118—125, ont montré que l'introduction en concentration assez importante (typiquement de l'ordre de $10^{19}$ atomes/cm$^3$) d'un ion de taille légèrement différente de celle des constituants des substrats en GaAs permettaient de diminuer le taux de dislocation.

Afin que les substrats conservent leur propriété semi-isolante, on utilise des ions isoélectriques de l'un des constituants, arsénic ou gallium, de ces substrats. L'article ci-dessus decrit l'emploi d'ions d'azote, de bore, de phosphore, d'indium et d'antimoine. Le dopant le plus utilisé à ce jour est l'indium et la concentration en dopant varie de $10^{19}$ à $5.10^{20}$ atomes/cm$^3$. Un tel dopage d'indium d'un substrat en GaAs permet d'obtenir des cristaux pratiquement exempts de dislocations; on descend à l'heure actuelle jusqu'à $10^2$ dislocations par cm$^2$. Malheureusement, la dimension des cristaux obtenue ne dépasse pas 5 cm de diamètre.

Par ailleurs, lorsque cette technique de diminution des dislocations est associée à la croissance des cristaux en surstoechiométrie d'arsenic pour créer des anti-sites dans le substrat en GaAs, il est pratiquement impossible d'obtenir des substrats monocristallins. Cette impossibilité serait liée à la surstoechiométrie en arsenic du bain à partir duquel sont formés les monocristaux. On recherche donc actuellement des techniques de compensation des impuretés résiduelles des substrats en GaAs ne nécessitant pas l'utilisation d'une surcomposition en arsenic.

La présente invention a justement pour objet un procédé de fabrication d'un substrat semi-isolant en matériau III—V permettant de remédier aux différents inconvénients donnés ci-dessus. Elle permet l'obtention de monocristaux en matériau III—V de grandes dimensions ne présentant pas de dislocations et qui sont stables thermiquement.

De façon plus précise, l'invention a pour objet un procédé de fabrication d'un substrat monocristallin semi-isolant, non disloqué, de formule AB dans laquelle A et B représentent respectivement un élément de la colonne III et un élément de la colonne V du tableau périodique des éléments, consistant à faire croître un monocristal AB à partir d'un bain fondu et à doper ledit bain par des ions d'un métal de transition servant à compenser les impuretés du substrat, caractérisé en ce que, pour rendre ce substrat stable thermiquement lors d'une étape de recuit dudit substrat, le concentration des ions du métal de transition dans le bain fondu est telle que la concentration C de ces ions dans le substrat AB est au plus égale à la solubilité limite de ces ions dans ledit substrat à la température du recuit, la concentration des impuretés du substrat étant inférieure à ladite concentration C, et en ce que l'on dope le bain fondu par des ions d'un élément de la colonne III ou V du tableau périodique différent de A et de B.

Ce procédé permet, à une température de recuit prédéterminée du substrat en matériau III—V, d'éviter l'exodiffusion des ions du métal de transition introduit dans le substrat lors d'une étape de recuit ultérieure du substrat, consécutif notamment à une implantation d'ions dans ledit substrat, pour former des circuits intégrés ou des transistors à effet de champ. Le substrat monocristallin obtenu par le procédé de l'invention garde donc parfaitement son caractère semi-isolant, même après un recuit.

Afin de permettre la compensation des impuretés du substrat par des ions métalliques de transition, il est souhaitable que la concentration de ces impuretés soit aussi faible que possible. A cet effet, on utilisera de préférence selon l'invention, un creuset en nitrure de bore, obtenu par exemple par pyrolyse, pour contenir le bain fondu. Ce matériau présente l'avantage d'être formé d'éléments isoélectriques de ceux constituant le substrat. En outre, on utilisera un encapsulant liquide du bain fondu, la température de fusion de l'encapsulant étant inférieure à celle du substrat en matériau III—V. Comme encapsulant liquide, on utilise par exemple de l'oxyde de bore ($B_2O_3$).

La technique de croissance d'un monocristal à partir d'un bain fondu contenu dans un creuset en nitrure de bore et encapsulé dans un encapsulant liquide, est communément appelé technique de croissance LEC (Liquid Encapsulated Czochralski en terminologie anglosaxonne).

Cette technique de croissance est extrêmement propre et permet d'obtenir des substrats en matériau III—V dont la concentration en impuretés résiduelles est de l'ordre de $10^{15}$ atomes/cm$^3$.

Le procédé selon l'invention présente l'avantage d'être applicable à un grand nombre de matériaux III—V et en particulier à l'arséniure de gallium, à l'arséniure d'indium, au phosphure d'indium, à l'antimoniure d'indium et à l'antimoniure de gallium.

Dans le cas d'un substrat en GaAs, on utilise avantageusement comme métal de transition, le chrome. La concentration C en chrome du substrat en GaAs varie de $10^{15}$ à $6.10^{15}$ atomes/cm$^3$. La température de recuit du substrat est comprise entre 850 et 950°C. Ces températures de recuit sont celles généralement utilisées pour guérir les défauts créés dans un substrat en GaAs lors d'une implantation ionique dans ce substrat. A ces températures de recuit, la solubilité limite des ions chrome dans le substrat en GaAs est égale à $6.10^{15}$ atomes/cm$^3$.

Etant donné que le chrome crée un centre électro-accepteur profond dans le substrat, la compensation des impuretés résiduelles du substrat ne peut être réalisée par le chrome qu'à condition que ces impuretés soient des uimpuretés électro-donneuses. Or, le substrat monocristallin en GaAs obtenu par croissance LEC contient principalement comme impuretés du carbone, qui sont des impuretés de type p, provenant essentiellement du gaz carbonique de l'air.

Pour permettre la compensation par le chrome, on effectue alors, selon l'invention, un dopage du bain fondu par des ions de type n, la concentration de ces ions de type n étant légèrement supérieure à celle des ions de type p (carbone), mais inférieure à la concentration C utilisable des ions chrome. Le dopage de type n du substrat en GaAs peut être réalisé avec des ions de silicium, de soufre, de sélénium, de tellure, d'étain, etc. On utilise en particulier des ions de silicium.

Pour un substrat en InP, on utilise avantageusement commè ions métalliques, de transition pour compenser les impuretés de ce substrat, des ions de fer. La température de recuit généralement utilisée pour un substrat en InP est comprise entre 700°C et 800°C. La concentration C en ions fer du substrat varie de $10^{15}$ à $4.10^{15}$ atomes/cm$^3$. Entre 700 et 800°C la solubilité limite du fer dans un substrat en InP est de $4.10^{15}$ atomes/cm$^3$.

Les substrats en matériau III—V monocristallins sont, grâce au dopage du bain fondu par des ions d'un élément de la colonne III ou V différents de ceux formant le substrat, peu disloqués.

Pour un substrat en GaAs, on peut utiliser comme élément isoélectrique dopant du bore, de l'aluminium, de l'azote, du phosphore, de l'indium ou de l'antimoine. La concentration de cet élément dopant dans le substrat monocristallin peut être comprise entre $5.10^{18}$ et $5.10^{20}$ atomes/cm$^3$. Dans un substrat en GaAs, une telle concentration d'ions indium permet de limiter le nombre de dislocations de ce substrat à environ $10^2$/cm$^2$.

Dans le cas d'un substrat en InP, on peut utiliser comme élément dopant iso-électrique de ceux du sustrat le bore, l'aluminium, l'azote, le gallium, l'arsenic ou l'antimoine. La concentration de cet élément dopant dans le substrat peut varier de $5.10^{18}$ à $5.10^{20}$ atomes/cm$^3$. De préférence, on utilise le gallium.

D'autres caractéristiques et avantages de l'invention ressortiront mieux de la description qui va suivre donnée à nitre illustratif et non limitatif.

La description ci-après se référe à la fabrication d'un substrat mono-cristallin semi-isolant en GaAs. Ce substrat est non disloqué et stable à une température de recuit allant de 850 à 950°C et valant en particulier 900°C. Ce substrat en GaAs est obtenu par la technique de croissance LEC bien connue de l'homme de l'art. Un des dispositifs permettant la mise en oeuvre de cette technique de croissance est décrite dans l'article de R. K. Willardson, page 104, cité précédemment.

Dans un creuset en nitrure de bore, placé dans une enceinte étanche, éventuellement sous pression ($2.10^5$ Pa par exemple), on réalise un mélange d'arsenic et de gallium en quantités stoechiométriques. A ce mélange, on ajoute 0,1% en poids de chrome, 0,09% en poids d'indium et 0,09% en poids de silicium. Ces concentrations tiennent compte des coefficients de ségrégation des différents éléments, c'est-à-dire du nombre d'atomes entrant effectivement dans la composition du substrat mono-cristallin en GaAs. En particulier, dans le cas du chrome, un atome sur $10^4$ atomes contenus dans le bain entre dans la composition du substrat monocristallin. Malgré la surcharge en chrome, on obtient un lingot mono-cristallin semi-isolant en GaAs dont la concentration en chrome varie, dans le lingot même, de $2^{15}$ à $6^{15}$ atomes/cm$^3$ sur 80% de la longueur du lingot. Les 20% restants du lingot sont aussi semi-isolants mais trop dopés en chrome. Compte tenu de l'exodiffusion prévisible du chrome dans la partie surdopée en chrome, il est préférable de ne pas utiliser cette partie lors de la fabrication de circuits intégrés ou de transistors à effet de champ.

Compte tenu du coefficient de ségrégation de l'indium et du silicium voisin de 1, on obtient un substrat en GaAs semi-isolant contenant $2^{15}$ atomes de silicium par cm$^3$, ce qui est largement suffisant pour compenser les impuretés en carbone, dont la concentration est typiquement de $1,5.10^{15}$ atomes/cm$^3$, et contenant $5.10^{19}$ atomes d'indium par cm$^3$.

Le procédé selon l'invention a permis aussi la fabrication d'un substrat en InP semi-isolant, non disloqué, stable thermiquement à des températures comprises entre 700 et 800°C et en particulier voisines de 750°C. Les impuretés résiduelles d'un tel substrat étant principalement de type n, et spécialement du silicium provenant de la fabrication même des produits de départ, l'indium et le phosphore, il n'est pas nécessaire de réaliser un contre dopage comme dans le cas du GaAs. Ces impuretés résiduelles de type n dont la concentration est légèrement inférieure à $10^{15}$ atomes/cm$^3$, peuvent être compensées directement par un dopage en fer du substrat en InP de façon à ce que ce substrat soit semi-isolant. La concentration en fer dans le substrat varie de $10^{15}$ à $4.10^{15}$ atomes/cm$^3$.

Par ailleurs, ce substrat en InP contient $5.10^{19}$ atomes/cm$^3$ de gallium pour réduire le nombre de dislocations de ce substrat.

Compte tenu des coefficients de ségrégation du fer et du gallium valant respectivement $10^{-4}$ et 0,3, il faut prévoir dans le bain fondu à partir duquel est formé le monocristal une surcharge en fer et une surcharge en gallium.

En outre, étant donné la forte volatilité du phosphore, la croissance LEC du substrat est réalisée sous pression élevée et à environ $27.10^5$Pa.

La description ci-dessus n'a bien entendu été donnée qu'à titre explicatif. En particulier, pour obtenir un substrat en GaAs semi-isolant, il est possible de remplacer le chrome par un autre métal de transition. Lorsque ce dernier est comme le chrome électro-accepteur, un contre-dopage par des ions de type n du substrat en GaAs doit être prévu. En revanche, lorsque le métal de transition utilisé créé dans le substrat des centres électro-donneurs, la compensation des impuretés résiduelles telles que le carbone du substrat en GaAs peut être réalisée directement. Dans les mêmes conditions, on peut envisager, pour un substrat en InP, de remplacer le fer par un autre métal de transition.

La procédé de fabrication selon l'invention d'un substrat en matériau III—V permet d'obtenir, contrairement à l'état de la technique, un substrat parfaitement semi-isolant, non disloqué et stable thermiquement. Ces substrats monocristallins peuvent donc être utilisés avantageusement pour la fabrication de transistors à effet de champ ou de circuits intégrés logiques.

D'après les inventeurs, il semblerait que le processus de diffusion rapide d'un ion de transition dans un substrat en matériau III—V se produit lorsque cet ion est en site intersticiel, le nombre de dislocations du substrat contribuant fortement à cette diffusion. Lorsque la concentration de ces ions de transition est inférieure à leur solubilité limite dans le substrat, à la température où se fait généralement le recuit de celui-ci, ces ions se sentent "à l'aise" dans le réseau cristallin et ne se redistribuent donc pas. Dans le cas d'un substrat en GaAs, les ions chrome introduits ont une forte tendance à aller en site gallium, plutôt qu'en site intersticiel, ce qui réduit et même évite totalement la diffusion du chrome hors du substrat.

De plus, le fait que le substrat soit pratiquement exempt de dislocation contribue aussi à la faible diffusion de l'ion de transition hors du substrat.

Cette interprétation peut être corroborée par de nombreuses données de la littérature qui n'ont pas été interprétées jusqu'à ce jour.

Une fois admise cette interprétation, il suffit de connaître la limite de solubilité de l'ion de transition utilisé à la température où se fera une recuit du substrat, notamment consécutif à une implantation ionique dans ledit substrat.

La limite de solubilité des ions d'un métal de transition dans un substrat en matériau III—V, à une température donnée du recuit de ce substrat, peut être déterminée en dopant fortement ce substrat, en implantant par exemple des ions de bore, puis en recuisant le substrat ainsi dopé à la température de recuit souhaitée. On effectue alors une mesure de la concentration en ions de transition restante, par exemple à l'aide d'une sonde ionique ou par absorption nucléaire.

**Revendications**

1. Procédé de fabrication d'un substrat monocristallin semi-isolant, non disloqué, de formule AB dans laquelle A et B représentent respectivement un élément de la colonne III et un élément de la colonne V du tableau périodique des éléments, consistant à faire croître un monocristal AB à partir d'un bain fondu et à doper ledit bain par des ions d'un métal de transition servant à compenser les impuretés du substrat, caractérisé en ce que, pour rendre ce substrat stable thermiquement lors d'une étape de recuit dudit substrat, la concentration des ions du métal de transition dans le bain fondu est telle que la concentration C de ces ions dans le substrat AB est au plus égale à la solubilité limite de ces ions dans ledit substrat à la température du recuit, la concentration des impuretés du substrat étant inférieure à ladite concentration C, et en ce que l'on dope le bain fondu par des ions d'un élément de la colonne III ou V du tableau périodique différent de A et de B.

2. Procédé de fabrication selon la revendication 1, caractérisé en ce que le bain fondu est formé dans un creuset en nitrure de bore.

3. Procédé de fabrication selon la revendication 1 ou 2, caractérisé en ce que le bain fondu est encapsulé dans un encapsulant liquide dont la température de fusion est inférieure à celle du substrat.

4. Procédé de fabrication selon la revendication 1, caractérisé en ce que le substrat AB est choisi parmi le GaAs, l'InP, le GaSb, l'InAs et l'InSb.

5. Procédé de fabrication selon la revendication 1, caractérisé en ce ce que l'élément dopant de la colonne III ou V est choisi parmi le bore, l'aluminium, l'azote, le phosphore, l'indium et l'antimoine pour un substrat en GaAs.

6. Procédé de fabrication selon la revendication 5, caractérisé en ce que l'élément dopant est l'indium.

7. Procédé de fabrication selon la revendication 1, caractérisé en ce que le métal de transition est le chrome pour un substrat en GaAs.

8. Procédé de fabrication selon la revendication 7, caractérisé en ce que la température de recuit du substrat en GaAs étant comprise entre 850°C et 950°C, la concentration C en oins chrome du substrat est inférieure à $6.10^{15}$ at/cm³.

9. Procédé de fabrication selon la revendication 1, caractérisé en ce que l'élément dopant de la colonne III ou V est choisi parmi le bore, l'aluminium, l'azote, le gallium, l'arsenic et l'antimoine pour un substrat en InP.

10. Procédé de fabrication selon la revendication 9, caractérisé en ce que l'élément dopant est le gallium.

11. Procédé de fabrication selon la revendication 1, caractérisé en ce que le métal de transition est le fer pour un substrat en InP.

12. Procédé de fabrication selon la revendication 11, caractérisé en ce que la température de recuit du substrat en InP étant comprisé entre 700°C et 800°C, la concentration C en ions fer du substrat est inférieure à $4.10^{15}$ at/cm³.

13. Procédé de fabrication selon la revendication 7, caractérisé en ce que, pour le substrat en GaAs, on dope également le bain fondu par des ions de type n, ces ions formant les impuretés dudit substrat.

14. Procédé de fabrication selon la revendication 13, caractérisé en ce que les ions de type n sont des ions de silicium.

**Patentansprüche**

1. Verfahren zur Herstellung eines ungestörten, halbisolierenden monokristallinen Substrats der Formel AB, in dem A und B jeweils ein Element der Gruppe III und ein Element der Gruppe V des Periodischen Systems der Elemente darstellen, das darin besteht, daß man einen Einkristall AB aus einem geschmolzenen Bad wachsen läßt und das Bad mit Ionen einer Übergangsmetalls dotiert, die dazu dienen, die Verunreinigungen des Substrats zu kompensieren, dadurch gekennzeichnet, daß, um das Substrat in der Stufe des Bennens des Substrats wärmebeständig zu machen, die Konzentration der Ionen aus dem Übergangsmetall in dem geschmolzenem Bad so groß ist, daß die Konzentration C dieser Ionen in dem Substrat AB mindestens gleich der Löslichkeitsgrenze der Ionen in dem Substrat bei der Glühtemperatur ist, wobei die Konzentration der Verunreinigungen des Substrats unterhalb der Konzentration C liegt, und daß das geschmolzene Bad mit Ionen eines elements der Gruppe III oder V des Periodischen Systems der Elemente, das von A und B verschieden ist, dotiert wird.

2. Verfahren zur Herstellung nach Anspruch 1, dadurch gekennzeichnet, daß das geschmolzene Bad in einem Tiegel aus Bornitrid gebildet wird.

3. Verfahren zur Herstellung nach Anspruch 1 oder 2, dadurch gekennzeichnet, daß das geschmolzene Bad in einer Einkapselungsflüssigkeit eingekapselt wird, deren Schmelztemperatur unter derjenigen des Substrats liegt.

4. Verfahren zur Herstellung nach Anspruch 1, dadurch gekennzeichnet, daß das Substrat AB ausgewählt wird aus GaAs, InP, GaSb, InAs und InSb.

5. Verfahren zur Herstellung nach Anspruch 1, dadurch gekennzeichnet, daß für ein Substrat aus GaAs das Dotierungselement der Gruppe III oder V ausgewählt wird aus Bor, Aluminium, Stickstoff, Phosphor, Indium und Antimon.

6. Verfahren zur Herstellung nach Anspruch 5, dadurch gekennzeichnet, daß es sich bei dem Dotierungselement um Indium handelt.

7. Verfahren zur Herstellung nach Anspruch 1, dadurch gekennzeichnet, daß für ein Substrat aus GaAs das Übergangsmetall Chrom ist.

8. Verfahren zur Herstellung nach Anspruch 7, dadurch gekennzeichnet, daß die Temperatur, bei der das Substrat aus GaAs geglüht wird, zwischen 850 und 950°C liegt und daß die Konzentration C des Substrats an Chromionen unterhalb $6 \times 10^{15}$ at/cm$^3$ liegt.

9. Verfahren zur Herstellung nach Anspruch 1, dadurch gekennzeichnet, daß für ein Substrat aus InP das Dotierungselement der Gruppe III oder V ausgewählt wird aus Bor, Aluminium, Stickstoff, Gallium, Arsen und Antimon.

10. Verfahren zur Herstellung nach Anspruch 9, dadurch gekennzeichnet, daß es sich bei dem Dotierungselement um Gallium handelt.

11. Verfahren zur Herstellung nach Anspruch 1, dadurch gekennzeichnet, daß es sich für ein Substrat aus InP bei dem Übergangsmetall um Eisen handelt.

12. Verfahren zur Herstellung nach Anspruch 11, dadurch gekennzeichnet, daß die Temperatur, bei der das Substrat au NiP geglüht wird, zwischen 700 und 800°C liegt und daß die Konzentration C des Substrats an Eisenionen unterhalb $4 \times 10^{15}$ at/cm$^3$ liegt.

13. Verfahren zur Herstellung nach Anspruch 7, dadurch gekennzeichnet, daß für ein Substrat aus GaAs das geschmolzene Bad auch mit Ionen des Typs n dotiert wird, welche die Verunreinigungen des Substrats bilden.

14. Verfahren zur Herstellung nach Anspruch 13, dadurch gekennzeichnet, daß es sich bei den Ionen des Typs n um Siliciumionen handelt.

## Claims

1. Process for producing a non-dislocated, semi-insulating, monocrystalline substrate of formula AB, in which A and B respectively present an element of column III and an element of column V of the periodic table of elements, consisting of growing a monocrystal AB from a molten bath, and doping said bath with the ions of a transition metal used for compensating the impurities of the substrate, characterized in that in order to make said substrate thermally stable during an annealing stage thereof, the concentration of ions of the transition metal in the molten bath is such that the concentration C of said ions in substrate AB is the most equal to the limiting solubility of said ions in said substrate and at the annealing temperature, the concentration of impurities of the substrate being below said concentration C and in that the molten bath is doped by ions of an element of column III or V of the periodic table differing from A and B.

2. Production process according to claim 1, characterized in that the molten bath is formed in a boron nitride crucible.

3. Production process according to claims 1 or 2, characterized in that the molten bath is encapsulated in a liquid encapsulating agent, whose melting temperature is below that of the substrate.

4. Production process according to claim 1, characterized in that the substrate AB is chosen from among GaAs, InP, GaSb, InAs and InSb.

5. Production process according to claim 1, characterized in that the doping element of column III or V is chosen from among boron, aluminium, nitrogen, phosphorus, indium and antimony in the case of a GaAs substrate.

6. Production process according to claim 5, characterized in that the doping element is indium.

7. Production process according to claim 1, characterized in that the transition metal is chromium in the case of a GaAs substrate.

8. Production process according to claim 7, characterized in that the annealing temperature of the GaAs substrate is between 850 and 950°C and the concentration C of chromium ions of the substrate is below $6.10^{15}$ atoms/cm$^3$.

9. Production process according to claim 1, characterized in that the doping element of column III or V is chosen from among boron, aluminium, nitrogen, gallium, arsenic and antimony in the case of an InP substrate.

10. Production process according to claim 9, characterized in that the doping element is gallium.

11. Production process according to claim 1, characterized in that the transition metal is iron for an InP substrate.

12. Production process according to claim 11, characterized in that the annealing temperature of the InP substrate is between 700 and 800°C, the concentration C of iron ions of the substrate being below $4.10^{15}$ atoms/cm$^3$.

13. Production process according to claim 7, characterized in that, for the GaAs substrate, the molten bath is also doped by n-type ions, said ions forming the impurities of said bath.

14. Production process according to claim 13, characterized in that the n-type ions are silicon ions.